# EUROPEAN PATENT SPECIFICATION

(11) **EP 0 584 437 B1**
(45) Date of publication and mention of the grant of the patent: **07.06.2000**
(21) Application number: 92830456.7
(22) Date of filing: 26.08.1992
(51) Int. Cl.: H03F 1/32, H03F 3/45

(54) **Transconductor stage**
Transkonduktanzstufe
Etage transconducteur

(43) Date of publication of application: 02.03.1994
(73) Proprietor: STMicroelectronics S.r.l., 20041 Agrate Brianza (Milano) (IT)
(72) Inventor: Castello, Rinaldo, I-20043 Arcore (MI) (IT); Alini, Roberto, I-27049 Stradella (PV) (IT); Rezzi, Francesco, I-26039 Vescovato (CR) (IT); Pisati, Valerio, I-27049 Bosnasco (PV) (IT)
(74) Representative: Botti, Mario

(56) References cited:
- EP-A- 0 453 034
- GB-A- 2 175 763
- US-A- 5 095 284
- US-A- 5 304 869
- US-A- 5 332 937
- PROCEEDINGS OF THE IEEE 1988 CUSTOM INTEGRATED CIRCUITS CONFERENCE MAY 16-19 , 1988 16 May 1988, NEW- YORK pages 1211 - 1214 G.H. WARREN ET AL 'NOISE, CROSSTALK AND DISTORTION IN MIXED ANALOG/DIGITAL INTEGRATED CIRCUITS'
- CZARNUL C. ET AL: "MOS tunable transconductor", ELECTRONIC LETTERS, GB, 19. June 1986, vol. 22, no. 13, pages 721 to 722
- R. CASTELLO ET AL: "1.5-V High Performance SC Filters in BiCMOS Technology", IEEE JOURNAL OF SOLID-STATE CIRCUITS, New York, US, 01. July 1991, vol. 26, no. 7, pages 930 to 936

## Description

This invention relates to an improved transconductor stage for high-frequency filters, comprising an input circuit portion, including a pair of npn bipolar transistors having bases providing complementary signal inputs for the transconductor stage, and an output circuit portion.

The field of application of this invention is particularly, but not exclusively, related to monolithically integrated time-continued filters, and reference will be made in the description that follows to that field of application merely for convenience of illustration.

As is known, many are the time-continued integrated filter making techniques which have been proposed. Among these, the most promising techniques in terms of high-frequency performance are those which employ a transconductor stage as the filter base block.

This is likely to stem from that, since the voltage/current conversion takes place in open loop within the transconductor, the so-called non-dominant pole of the converter is not limited by the unity gain in frequency of the amplification.

The performance characteristics which are usually expected of a transconductor stage for high-frequency applications are basically the following ones:
- a capability to handle wide signals;
- low noise generation;
- low bias current;
- a high transconductance gm value; and
- a gain higher than 50 dB.

The prior art has already proposed a transconductor stage embodiment which has good performance characteristics approaching the above specifications. We refer in particular to a transconductor disclosed in Italian Patent Application No. MI91A 003018 by this Applicant, which is filed on Nov. 13 1991, and published on June 12, 1995.

A transconductance amplifier is described in that Application which is made in the mixed Bipolar/MOS technology and comprises an input circuit portion with a differential cell having two MOS transistors with their sources in common which are connected to an output circuit portion comprising a pair of bipolar transistors having their bases in common.

While being beneficial from several aspects, and substantially achieving its objective, this prior solution still has a drawback in that high transconductance values cannot be obtained thereby along with a low current draw and good linearity.

A second prior solution is described in an article "MOS Tunable Transconductor", Electronics Letters, 19th June, 1986, Vol. 22, No. 13, wherein a transconductor is suggested whose input stage has a pair of buffer-connected MOS transistors associated with two more MOS transistors forming the gain stage.

The first two MOS transistors, i.e. the buffer-connected ones, are responsible for most of the distortion in this amplifier type.

The other transistor pair have instead their substrates connected to ground and are, therefore, affected by an disfavorable "Body Effect". Accordingly, their threshold voltage is raised by some 0.5 Volts and narrows the overdrive value (Vgs-Vth) range that can be applied to the transistors for programming the transconductance gm value. The latter known solution has, moreover, a disdavantage in that it can only operate at a supply voltage of about ten volts.

A further solution is disclosed in the U.S. patent No. 5,304,869, filed on April 17, 1992, and published on April, 19, 1994 which relates to an integrated circuit amplifier stage including bipolar transistors and field effect transistors. The npn bipolar transistors have their collectors terminals both connected to the supply voltage. The drain of the PMOS transistor is the output terminal of the circuit.

Such a circuit is much sensible to input common mode variations.

The article by G.H. Warren et al. on "Noise crosstalk and distortion in mixed analog/digital integrated circuits", published in the Proceeding of the IEEE 1988 Custom Intergrated Circuits Conference, May 16-19, 1988, pages 12.1.1-12.1.4, relates to an amplifier stage including a pair of lateral bipolar npn input transistor and a biasing circuit including a pair of MOS transistors.

Each bipolar transistor is associated to a MOS transistor of a second pair of MOS transistors, while the collectors of the bipolar transistors are connected to the biasing circuit.

The GB patent application NO. 2 175 763 discloses a Transconductor stage including a MOS input pair. The MOS transistor are biased in their triode region.

The underlying technical problem of this invention is to provide a transconductor stage which has such structural and functional features as to overcome the above drawbacks besetting the prior art.

This technical problem is solved by a stage as indicated above and defined in the characterizing part of Claim 1.

The features and advantages of a transconductor stage according to the invention will become apparent from the following detailed description of an embodiment thereof, given by way of example and not of limitation with reference to the accompanying drawings.

In the drawings:
Figure 1 is a diagramatic representation of a transconductor stage according to the invention;
Figure 2 is a further diagram of the transconductor shown in Figure 1; and
Figures 3 and 4 are respective diagramatic views of examples of time-continued filters incorporating the transconductor stage of this invention.

With reference to the drawing views, generally and schematically indicated at 1 is a transconductor stage according to the invention adapted for handling very-high frequency (above 50 MHz) analog signals.

The stage 1 is realized in a mixed technology, including bipolar transistors as well as MOS-type transistors. This stage 1 comprises an input circuit portion having signal inputs A and B and incorporating a transistor pair M1, M2 of the N-channel MOS type having their respective gate terminals G1, G2 in common into a node P2. Said node P2 is supplied a constant current I3.

Said transistors M1, M2 also have in common their source terminals S1 and S2, coincident at a node P3. Further, the body of such transistors M1, M2 is connected to the source.

A constant voltage generator E is placed between said nodes P2 and P3, and a current generator It is provided between the node P3 and ground. The generator E may be a battery or, in quite an equivalent way, a resistor through which the current I3 is flown.

The transconductor 1 further comprises a second transistor pair Q1, Q2 which are of the bipolar npn junction type and the same size.

The base terminal B1 of the first, Q1, of these transistors constitutes a non-inverting signal input A for the stage 1, whilst the base terminal B2 of the second transistor, Q2, provides the other or inverting signal input B of the transconductor. At the inputs A and B, there are applied corresponding voltage signals Vi+ and Vi-; the differential voltage Vin of stage 1 being the difference (Vi+ minus Vi-) between such input signals.

Advantageously, each bipolar transistor, Q1 and Q2, is connected to its corresponding MOS transistor, M1 and M2, in the stage 1.

Specifically, the emitter E1 of the transistor Q1 is connected to the drain terminal D1 of the first MOS transistor M1.

Likewise, the emitter E2 of the transistor Q2 is connected to the drain terminal D2 of the second MOS transistor M2.

The respective collectors C1, C2 of the bipolar transistor pair Q1, Q2 are the outputs U1, U2 of the stage 1 through which differential currents I01 and I02 are flown.

An active load 3 is connected to said collectors C1, C2 which supplies a current Io from a DC supply Vd.

A description of the operation of the transconductor stage according to this invention will now be given, followed by that of an exemplary application thereof. In order to have the stage 1 biased within the linear operation range of transistors M1 and M2, such that a proper linear voltage/current conversion can be achieved, a common mode DC voltage should be first established, e.g.:$\text{Vi+ = Vi- = 2.5 Volts.}$ The drop in the gate-source voltage Vgs of each of the MOS transistor pair M1, M2 is set by the generator E such that the transconductance of the stage 1 can be specially stable and unaffected by such external noise as common mode variations.

Therefore, by an appropriate selection of the value for current Io, the drain-source voltage Vds drop of each MOS transistor, in the power-down state, can be the same and defined univocally by the following relation.${\text{Io = µ Cox (W/L)[(E-Vth)*Vds-Vds}}^{\text{2}} \text{/2]}$ where, µ, Cox, W, and L are known parameters of the transistors, Vth is the threshold voltage, and the single unknown quantity is indeed voltage Vds.

A typical value of this voltage Vds, effective to optimize the stage linearity, is on the order of 150-200 mV. Such a value also lowers the current draw without affecting the transconductance value. As for the bipolar transistors Q1 and Q2, these are directed to transfer the respective input signals Vi+ and Vi- on the drain terminals D1, D2. In addition, said bipolar transistors transfer the current generated by the transconductor stage to output.

For small input differential signals, the node P3 is held at a constant voltage value.

The transconductance gm value is given by the ratio of the output current differential increment to the input voltage, namely:$\text{gm = δIo/δVin = µ Cox (W/L)[E-Vth-Vds]}$ This equation (2) only holds, in fact, for small differential signals. In the presence of wide signals, the voltage at the node P3 would be no longer constant, and the transistors Q1, Q2 would be unable to fully transfer the input signal on the drain terminals D1 and D2. This obviously results in the output signal being distorted.

In any case, by appropriate selection of the value of Vds, the linear operation conditions of the stage 1 can be predetermined.

As an example:
1) with Vds = 150 mV, distortion is less than 1% for input signals characterized by a peak-to-peak range below 0.5 Volts;
2) with Vds = 300 mV, distortion is less than 1% for input signals characterized by a peak-to-peak range below 1 Volt.

It is interesting to observe that, for a given current draw, the circuit exhibits in the latter instance a transconductance value which is half that of the former instance.

Briefly stated, the transconductor stage of this invention can be optimized to fulfill a specific application demand both in terms of linearity and of transconductance gm value and current draw. It will be appreciated that this provides a high degree of flexibility in use.

The frequency limitation to the stage 1 being tied solely to the bipolar transistors Q1, Q2, it matters that such transistor have a low base resistance and high transition frequency. Further, the product of the collector resistance by the collector-substrate capacitance must also be quite small because it represents a so-called pole for the output current.

An exemplary application of the transconductor stage according to the invention will now be described.

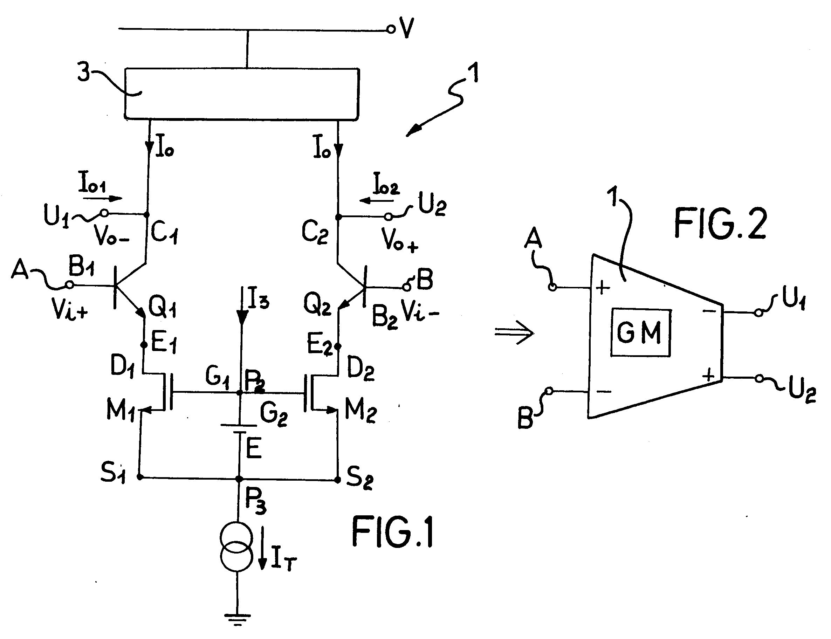

In Figure 2, the stage 1 is shown in a very schematic form illustrating it generally only.

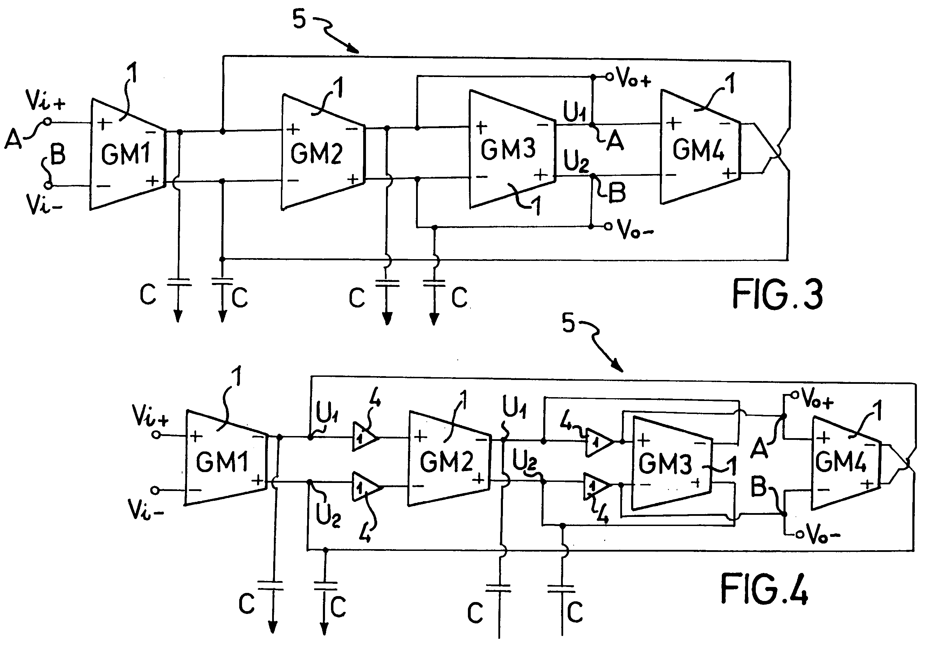

Figure 3 shows, based on the diagram of Figure 2, an embodiment of the time-continued low-pass filter 5 which incorporates some transconductor differential stages according to the invention, referenced GM1, GM2, GM3 and GM4.

The filter 5 may be monolithically integrated and is designed especially for very high-frequency (in excess of 50 MHz) applications.

Said filter is a second order one, it comprising a so-called biquadratic cell. The stages 1 are connected together in cascade arrangement with the outputs U1, U2 of one stage being connected to the respective inputs A, B of the next stage.

Conveniently, the fourth stage outputs are feedback-connected in a crossed fashion to the inputs of the second stage, whilst the third stage outputs are feedback-connected to the inputs of the third stage.

Also provided are capacitive couplings between the outputs of the first two stages and ground.

The filter 5 shown is specially effective where the dynamic range of the input signal is less than 200 mV peak-to-peak.

With higher dynamic ranges than this value, it is convenient to introduce buffer circuits 4 to prevent distortion of the signal.

Shown in Figure 4 is an exemplary application wherein the filter 5 has unity gain, buffer circuits incorporated thereto before the signal inputs of the second and third filter stages.

The transconductor stage of this invention does solve the technical problem and affords a number of advantages, of which outstanding is surely that of having, compared to known solutions, a transconductance value which is approximately three times as high. This enables handling of very high freuency signals, even in excess of 50 Mhz.

The solution proposed by this invention can operate even with a voltage supply of about 3.3 Volts, while keeping distortion low and the transconductance value high.

Understandably, this solution may be altered and modified within the invention scope as defined in the appended claims.

## Claims

1. A transconductor stage for high-frequency filters, comprising an input circuit portion, including a pair of npn bipolar transistors (Q1, Q2) having bases (B1, B2) providing complementary signal inputs for the transconductor stage (1), and an output circuit portion, characterized in that it comprises a bias circuit portion including a pair of field-effect transistors (M1, M2) having respective gate (G1, G2) and source (S1, S2) terminals in common, and that said output portion comprises said pair of bipolar transistors (Q1, Q2) having respective emitters (E1, E2) connected to a corresponding one of the drain terminals (D1, D2) of the other pair of field-effect transistors (M1, M2), and having respective collectors terminals (C1, C2) which are the outputs (V1, V2) of the stage (1).

2. A transconductor stage according to Claim 1, characterized in that a constant voltage (E) generator is provided between said common gate (G1, G2) and source (S1, S2) terminals.

3. A transconductor stage according to Claim 1, characterized in that said transistors (Q1, Q2) are of the same size.

4. A transconductor stage according to Claim 1, characterized in that, for said field-effect transistors (M1, M2), the drain-source voltage (Vds) drop value is predetermined by the type of the application for which the stage (1) is intended.

5. A transconductor stage according to Claim 1, characterized in that said field-effect transistors (M1, M2) are of the MOS type.

6. A low-pass filter (5) of the second order, characterized in that it incorporates at least one transconductor differential stage (1) as claimed in Claim 1.

## Patentansprüche

1. Transkonduktanzstufe für Hochfrequenzfilter, umfassend einen Eingangsschaltungsteil mit einem Paar von NPN-Bipolartransistoren (Q1, Q2), deren Basen (B1, B2) komplementäre Signaleingänge für die Transkonduktanzstufe (1) bilden, und einen Ausgangsschaltungsteil, dadurch gekennzeichnet, daß sie einen Vorspannungsschaltungsteil mit einem Paar von Feldeffekttransistoren (M1, M2) aufweist, deren Gateanschlüsse (G1, G2), sowie Sourceanschlüsse (S1, S2) zusmmengeschaltet sind, und daß der Ausgangsteil das Paar von Bipolartransistoren (Q1, Q2) aufweist, deren Emitter (E1, E2) an einen entsprechenden Drainanschluß (D1, D2) des anderen Paares von Feldeffekttransistoren (M1, M2) angeschlossen sind, und deren Kollektoranschlüsse (C1, C2) die Ausgänge (U1, U2) der Stufe (1) bilden.

2. Transkonduktanzstufe nach Anspruch 1, dadurch gekennzeichnet, daß eine Konstantspannungsquelle (E) zwischen den zusammengeschalteten Gateanschlüssen (G1, G2) und Sourceanschlüssen (S1, S2) vorgesehen ist.

3. Transkonduktanzstufe nach Anspruch 1, dadurch gekennzeichnet, daß die Transistoren (Q1, Q2) gleiche Größe aufweisen.

4. Transkonduktanzstufe nach Anspruch 1, dadurch gekennzeichnet, daß bei den Feldeffekttransistoren (M1, M2) der Drain-Source-Spannungsabfall (Vds) durch die Art der Anwendung bestimmt wird, für die die Stufe (1) vorgesehen ist.

5. Transkonduktanzstufe nach Anspruch 1, dadurch gekennzeichnet, daß die Feldeffekttransistoren (M1, M2) vom MOS-Typ sind.

6. Tiefpaßfilter (5) zweiter Ordnung, dadurch gekennzeichnet, daß es mindestens eine Transkonduktanz-Differenzstufe (1) gemäß Anspruch 1 enthält.

## Revendications

1. Etage transconducteur pour filtres haute fréquence, comportant une partie circuit d'entrée, comprenant une paire de transistors bipolaires npn (Q1, Q2) ayant des bases (B1, B2) fournissant des signaux d'entrées complémentaires à l'étage transconducteur (1), et une partie circuit de sortie, **caractérisé en ce qu'**il comporte une partie circuit de polarisation comprenant une paire de transistors à effet de champ (M1, M2) ayant respectivement leurs bornes de grille (G1, G2) et de source (S1, S2) en commun et en ce que ladite partie de sortie est constituée de ladite paire de transistors bipolaires (Q1, Q2), dont les émetteurs respectifs (E1, E2) sont reliés à la borne correspondante des bornes de drain (D1, D2) de l'autre paire de transistors à effet de champ (M1, M2), et dont les bornes de collecteurs respectives (C1, C2) forment les sorties (U1, U2) de l'étage (1).

2. Etage transconducteur selon la revendication 1, **caractérisé en ce qu'**un générateur (E) de tension constante est connecté entre lesdites bornes communes de grille (G1, G2) et de source (S1, S2).

3. Etage transconducteur selon la revendication 1, **caractérisé en ce que** lesdits transistors (Q1, Q2) sont de la même taille.

4. Etage transconducteur selon la revendication 1, **caractérisé en ce que**, pour lesdits transistors à effet de champ (M1, M2), la valeur de la chute de tension drain-source (Vds) est prédéterminée par le type d'application à laquelle est destiné l'étage (1).

5. Etage transconducteur selon la revendication 1, **caractérisé en ce que** lesdits transistors à effet de champ (M1, M2) sont de type MOS.

6. Filtre passe-bas (5) du deuxième ordre, **caractérisé en ce qu'**il incorpore au moins un étage différentiel transconducteur (1) selon la revendication 1.
